# EUROPEAN PATENT APPLICATION

(11) **EP 4 426 074 A1**
(43) Date of publication of application: **04.09.2024**
(21) Application number: 23798867.0
(22) Date of filing: 13.10.2023
(51) Int. Cl.: H05K 1/02, H05K 3/28, H05K 1/14, H05K 1/11

(54) **ELECTRONIC DEVICE COMPRISING GROUND STRUCTURE FOR FLEXIBLE PRINTED CIRCUIT BOARD**

(30) Priority: 19.01.2023 KR 20230008205; 23.02.2023 KR 20230024240
(71) Applicant: Samsung Electronics Co., Ltd., Suwon-si, Gyeonggi-do 16677 (KR)
(72) Inventor: KIM, Minki, Suwon-si, Gyeonggi-do 16677 (KR); RA, Jaeyeon, Suwon-si, Gyeonggi-do 16677 (KR); SONG, Yongjae, Suwon-si, Gyeonggi-do 16677 (KR)
(74) Representative: Nederlandsch Octrooibureau
(86) International application number: PCT/KR2023/015781
(87) International publication number: WO 2024/154892

(57) **Abstract**

According to an embodiment, an electronic device includes a flexible printed circuit board including a deformable region and a substrate. The substrate includes a first surface in a third region that includes a ground region including a first ground plane and a second ground plane spaced apart from the first ground plane, and a signal line disposed between the first ground plane and the second ground plane, a second surface opposite to the first surface and including a ground layer, and a third surface between the first surface and the second surface. The third region may include a conductive member extending from at least a portion of the ground region across over the third surface to the ground layer on the second surface.

## Description

### [Technical Field]

Embodiments to be described later relate to an electronic device including a ground structure for a flexible printed circuit board.

### [Background Art]

As an electronic device performs various functions according to user requests, the electronic device may include a plurality of printed circuit boards (PCBs). A plurality of electronic components of an electronic device may be disposed on the same printed circuit board or on different printed circuit boards to form an electrical connection inside the electronic device. As an electronic device becomes smaller, a printed circuit board may be disposed within the electronic device, in a partially deformable state to secure an arrangement space for the electronic components.

### [Disclosure]

### [Technical Solution]

According to an embodiment, an electronic device may comprise a first electronic component, a second electronic component, and a flexible printed circuit board for an electrical path between the first electronic component and the second electronic component including a first region, a second region spaced apart from the first region, a third region that extends from the first region to the second region and is deformable, and a substrate. The substrate in the third region may include a first surface on which a ground region including a first ground plane and a second ground plane spaced apart from the first ground plane, and a signal line between the first ground plane and the second ground plane and providing the electrical path are disposed, a second surface opposite to the first surface and on which a ground layer is disposed, and a third surface between the first surface and the second surface. The third region may include a conductive member extending from at least a portion of the ground region on the first surface across over the third surface to the ground layer on the second surface so as to electrically connecting at least a portion of the ground region and the ground layer.

According to an embodiment, an electronic device may comprise a first electronic component, a second electronic component, and a flexible printed circuit board for an electrical path between the first electronic component and the second electronic component including a first region, a second region spaced apart from the first region, a third region that extends from the first region to the second region and is deformable, and a substrate. The substrate in the third region may include a first surface on which a ground region including a first ground plane and a second ground plane spaced apart from the first ground plane and disposed in a closer distance to the third surface than the first ground plane, and a signal line between the first ground plane and the second ground plane and providing the electrical path, are disposed, a second surface opposite to the first surface and on which a ground layer is disposed, and a third surface between the first surface and the second surface. Each of the first region and the second region may include at least one conductive via penetrating at least a portion of the substrate. The third region may include a conductive member extending from at least a portion of the ground region on the first surface across over the third surface to the ground layer on the second surface so as to electrically connecting at least a portion of the ground region and the ground layer.

### [Description of the Drawings]

FIG. 1 is a block diagram of an electronic device in a network environment according to an embodiment.
FIG. 2 is a diagram illustrating an electronic device according to an embodiment.
FIG. 3 is an exploded perspective view of an electronic device according to an embodiment.
FIG. 4A is a top plan view of a flexible printed circuit board within an exemplary electronic device.
FIG. 4B is a cross-sectional view of an exemplary flexible printed circuit board cut along line A-A' of FIG. 4A.
FIG. 4C is a cross-sectional view of an exemplary flexible printed circuit board cut along line B-B' of FIG. 4A.
FIG. 5A illustrates an exemplary flexible printed circuit board.
FIGS. 5B and 5C illustrate an exemplary flexible printed circuit board cut along line C-C' of FIG. 5A.
FIGS. 6A, 6B, and 6C illustrate a third region of an exemplary flexible printed circuit board.
FIG. 6D is a graph illustrating a relationship between a signal loss of a signal line in a flexible printed circuit board and a frequency.
FIGS. 7A and 7B illustrate an exemplary flexible printed circuit board.

### [Mode for Invention]

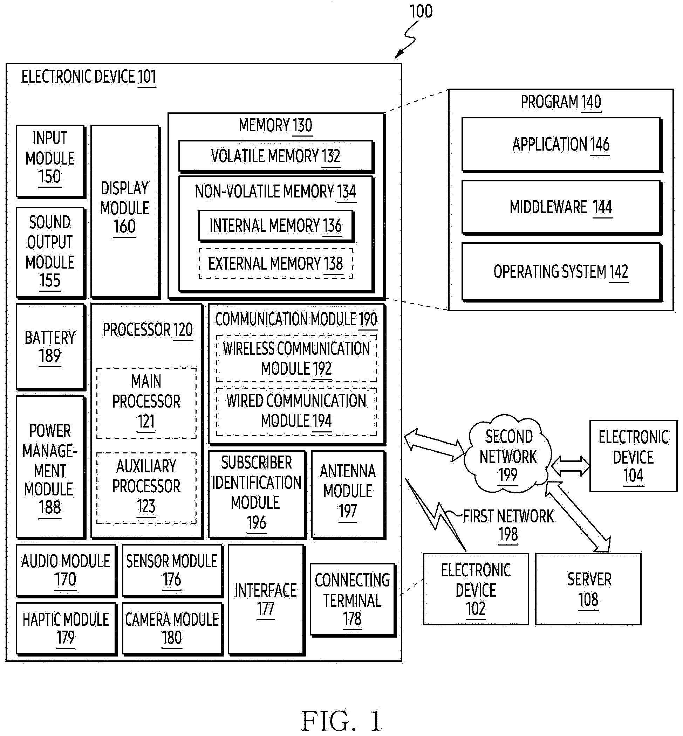

FIG. 1 is a block diagram of an electronic device in a network environment according to an embodiment.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a colour sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analogue beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

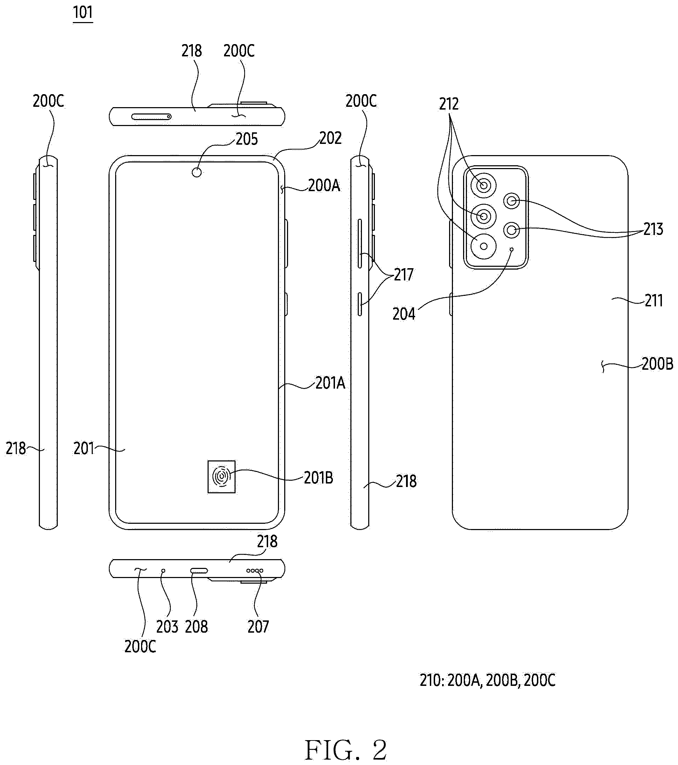

FIG. 2 is a diagram illustrating an electronic device according to an embodiment.

Referring to FIG. 2, an electronic device 101 according to an embodiment may include a housing 210 forming an exterior of the electronic device 101. For example, the housing 210 may include a front surface 200A, a rear surface 200B, and a side surface 200C surrounding a space between the front surface 200A and the rear surface 200B. According to an embodiment, the housing 210 may refer to a structure forming at least a portion of the front surface 200A, the rear surface 200B, and/or the side surface 200C.

The electronic device 101 according to an embodiment may include a substantially transparent front plate 202. According to an embodiment, the front plate 202 may form at least a portion of the front surface 200A. According to an embodiment, the front plate 202 may include, for example, a glass plate including various coating layers or a polymer plate, but the disclosure is not limited thereto.

The electronic device 101 according to an embodiment may include a substantially opaque rear plate 211. According to an embodiment, the rear plate 211 may form at least a portion of the rear surface 200B. According to an embodiment, the rear plate 211 may be formed of coated or coloured glass, ceramic, polymer, metal (e.g., aluminium, stainless steel (STS), or magnesium), or a combination of at least two of the above materials.

The electronic device 101 according to an embodiment may include a side structure (or side member) 218. According to an embodiment, the side structure 218 may be coupled to the front plate 202 and/or the rear plate 211 to form at least a portion of the side surface 200C of the electronic device 101. For example, the side structure 218 may form all of the side surface 200C of the electronic device 101, and for another example, the side structure 218 may form the side surface 200C of the electronic device 101 together with the front plate 202 and/or the rear plate 211.

Unlike the illustrated embodiment, in the case that the side surface 200C of the electronic device 101 is partially formed by the front plate 202 and/or the rear plate 211, the front plate 202 and/or the rear plate 211 may include a region that is bent from its periphery toward the rear plate 211 and/or the front plate 202 and seamlessly extends. The extended region of the front plate 202 and/or the rear plate 211 may be positioned at both ends of, for example, a long edge of the electronic device 101, but the disclosure is not limited to the above-described examples.

According to an embodiment, the side structure 218 may include a metal and/or a polymer. According to an embodiment, the rear plate 211 and the side structure 218 may be integrally formed and may include the same material (e.g., a metal material such as aluminium), but the disclosure is not limited thereto. For example, the rear plate 211 and the side structure 218 may be formed in separate configurations and/or may include different materials.

According to an embodiment, the electronic device 101 may include at least one of a display 201, an audio module 203, 204 and 207, a sensor module (not shown), a camera module 205, 212, 213, a key input device 217, a light emitting device (not shown), and/or a connector hole 208. According to another embodiment, the electronic device 101 may omit at least one of the components (e.g., a key input device 217 or a light emitting device (not shown)), or may further include another component.

According to an embodiment, the display 201 may be visually exposed through a substantial portion of the front plate 202. For example, at least a portion of the display 201 may be visible through the front plate 202 forming the front surface 200A. According to an embodiment, the display 201 may be disposed on the second surface of the front plate 202.

According to an embodiment, the appearance of the display 201 may be formed substantially the same as the appearance of the front plate 202 adjacent to the display 201. According to an embodiment, in order to expand the area in which the display 201 is visually exposed, the distance between the outside of the display 201 and the outside of the front plate 202 may be formed to be generally the same.

According to an embodiment, the display 201 (or the front surface 200A of the electronic device 101) may include a screen display area 201A. According to an embodiment, the display 201 may provide visual information to a user through the screen display area 201A. In the illustrated embodiment, when the front surface 200A is viewed from the front, it is illustrated that the screen display area 201A is spaced apart from the outside of the front surface 200A and is positioned inside the front surface 200A, but the disclosure is not limited thereto. In another embodiment, when the front surface 200A is viewed from the front, at least a portion of the periphery of the screen display area 201A may substantially coincide with the periphery of the front surface 200A (or the front plate 202).

According to an embodiment, the screen display area 201A may include a sensing area 201B configured to obtain biometric information of a user. Here, the meaning of "the screen display area 201A including the sensing area 201B" may be understood to mean that at least a portion of the sensing area 201B may be overlapped on the screen display area 201A. For example, the sensing area 201B, like other areas of the screen display area 201A, may refer to an area in which visual information may be displayed by the display 201 and additionally biometric information (e.g., fingerprint) of a user may be obtained. In another embodiment, the sensing area 201B may be formed in the key input device 217.

According to an embodiment, the display 201 may include an area in which the first camera module 205 is positioned. According to an embodiment, an opening may be formed in the area of the display 201, and the first camera module 205 (e.g., a punch hole camera) may be at least partially disposed in the opening to face the front surface 200A. In such a case, the screen display area 201A may surround at least a portion of the periphery of the opening. According to an embodiment, the first camera module 205 (e.g., an under display camera (UDC)) may be disposed under the display 201 to overlap the area of the display 201. In this case, the display 201 may provide visual information to the user through the area, and additionally, the first camera module 205 may obtain an image corresponding to a direction facing the front surface 200A through the area of the display 201.

According to an embodiment, the display 201 may be coupled to or disposed adjacent to a touch sensing circuit, a pressure sensor capable of measuring the intensity (pressure) of the touch, and/or a digitizer that detects a magnetic field type stylus pen.

According to an embodiment, the audio modules 203, 204 and 207 may include microphone holes 203 and 204, and a speaker hole 207.

According to an embodiment, the microphone holes 203 and 204 may include a first microphone hole 203 formed in a partial area of the side surface 200C and a second microphone hole 204 formed in a partial area of the rear surface 200B. A microphone (not shown) for obtaining an external sound may be disposed inside the microphone holes 203 and 204. The microphone may include a plurality of microphones to detect the direction of sound.

According to an embodiment, the second microphone hole 204 formed in a partial area of the rear surface 200B may be disposed adjacent to the camera modules 205, 212 and 213. For example, the second microphone hole 204 may obtain sound according to operations of the camera modules 205, 212, and 213. However, the disclosure is not limited thereto.

According to an embodiment, the speaker hole 207 may include an external speaker hole 207 and a receiver hole (not illustrated) for a call. The external speaker hole 207 may be formed on a portion of the side surface 200C of the electronic device 101. According to an embodiment, the external speaker hole 207 may be implemented as a single hole together with the microphone hole 203. Although not illustrated, a receiver hole (not shown) for a call may be formed on another portion of the side surface 200C. For example, the receiver hole for a call may be formed on the opposite side of the external speaker hole 207 on the side surface 200C. For example, with respect to the illustration of FIG. 2, the external speaker hole 207 may be formed on the side surface 200C corresponding to the lower end of the electronic device 101, and the receiver hole for a call may be formed on the side surface 200C corresponding to the upper end of the electronic device 101. However, the disclosure is not limited thereto, and according to an embodiment, the receiver hole for a call may be formed at a position other than the side surface 200C. For example, the receiver hole for a call may be formed by a space spaced apart between the front plate 202 (or display 201) and the side bezel structure 218.

According to an embodiment, the electronic device 101 may include at least one speaker (not illustrated) configured to output sound to the outside of the housing 210 through an external speaker hole 207 and/or a receiver hole (not shown) for a call.

According to an embodiment, the sensor module (not shown) may generate an electrical signal or data value corresponding to an internal operating state or an external environmental state of the electronic device 101. For example, the sensor module may include at least one of a proximity sensor, an HRM sensor, a fingerprint sensor, a gesture sensor, a gyro sensor, a pressure sensor, a magnetic sensor, an acceleration sensor, a grip sensor, a colour sensor, an infrared (IR) sensor, a biometric sensor, a temperature sensor, a humidity sensor, and an illumination sensor.

According to an embodiment, the camera modules 205, 212 and 213 may include a first camera module 205 disposed to face the front surface 200A of the electronic device 101, a second camera module 212 disposed to face the rear surface 200B, and a flash 213.

According to an embodiment, the second camera module 212 may include a plurality of cameras (e.g., a dual camera, a triple camera, or a quad camera). However, the second camera module 212 is not necessarily limited to including a plurality of cameras, and may include one camera.

According to an embodiment, the first camera module 205 and the second camera module 212 may include one or a plurality of lenses, an image sensor, and/or an image signal processor.

According to an embodiment, the flash 213 may include, for example, a light emitting diode or a xenon lamp. According to an embodiment, two or more lenses (infrared camera, wide-angle and telephoto lens) and image sensors may be disposed on one side of the electronic device 101.

According to an embodiment, the key input device 217 (e.g., an input module 150 of FIG. 1) may be disposed on the side surface 200C of the electronic device 101. According to an embodiment, the electronic device 101 may not include some or all of the key input devices 217, and the key input device 217 not included therein may be implemented on the display 201 in another form such as a soft key.

According to an embodiment, the connector hole 208 may be formed on the side surface 200C of the electronic device 101 to accommodate the connector of the external device. A connection terminal electrically connected to the connector of the external device may be disposed in the connector hole 208. The electronic device 101 according to an embodiment may include an interface module for processing electrical signals transmitted and received through the connection terminal.

According to an embodiment, the electronic device 101 may include a light emitting device (not shown). For example, the light emitting device (not shown) may be disposed on the front surface 200A of the housing 210. The light emitting device (not shown) may provide state information of the electronic device 101 in a form of light. In another embodiment, the light emitting device (not shown) may provide a light source when the first camera module 205 is operated. For example, the light emitting device (not shown) may include an LED, an IR LED, and/or a xenon lamp.

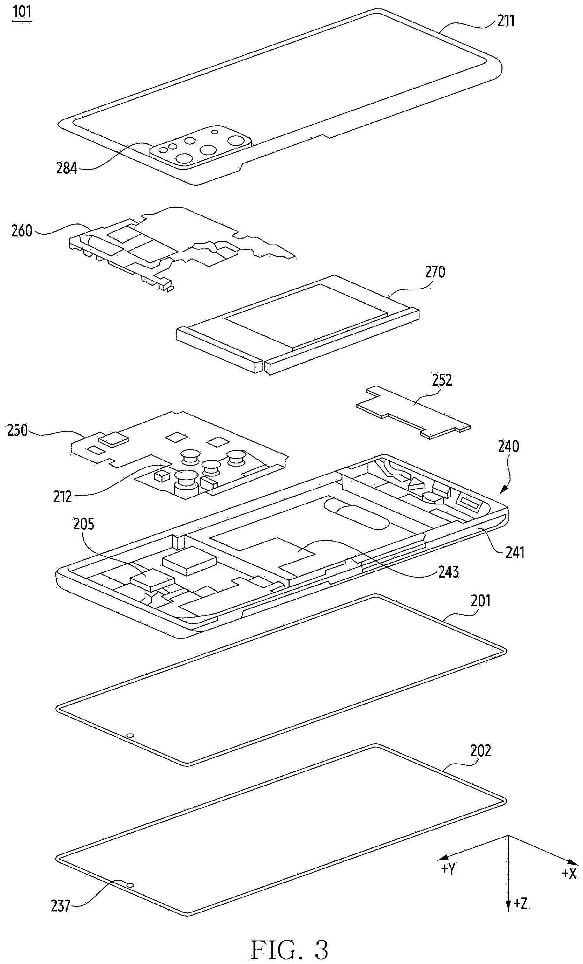

FIG. 3 is an exploded perspective view of an electronic device according to an embodiment.

Hereinafter, overlapping descriptions of components having the same reference numerals as those of the above-described components will be omitted.

Referring to FIG. 3, the electronic device 101 according to an embodiment may include a frame structure 240, a first printed circuit board 250, a second printed circuit board 252, a cover plate 260, and a battery 270.

According to an embodiment, the frame structure 240 may include a sidewall 241 forming an exterior (e.g., the third surface 200C of FIG. 2) of the electronic device 101 and a support portion 243 extending inward from the sidewall 241. According to an embodiment, the frame structure 240 may be disposed between the display 201 and the rear plate 211. According to an embodiment, the sidewall 241 of the frame structure 240 may surround a space between the rear plate 211 and the front plate 202 (and/or the display 201), and the support portion 243 of the frame structure 240 may extend from the sidewall 241 within the space.

According to an embodiment, the frame structure 240 may support or accommodate other components included in the electronic device 101. For example, the display 201 may be disposed on one surface of the frame structure 240 facing one direction (e.g., the +z direction), and the display 201 may be supported by the support portion 243 of the frame structure 240. For another example, a first printed circuit board 250, a second printed circuit board 252, a battery 270, and a rear camera 212 may be disposed on the other surface facing a direction opposite to the one direction (e.g., the -z direction) of the frame structure 240. The first printed circuit board 250, the second printed circuit board 252, the battery 270, and the rear camera 212 may be mounted on a recess defined by the sidewall 241 and/or the support portion 243 of the frame structure 240.

According to an embodiment, the first printed circuit board 250, the second printed circuit board 252, and the battery 270 may be coupled to the frame structure 240, respectively. For example, the first printed circuit board 250 and the second printed circuit board 252 may be fixedly disposed in the frame structure 240 through a coupling member such as a screw. For example, the battery 270 may be fixedly disposed on the frame structure 240 through an adhesive member (e.g., a double-sided tape). However, it is not limited by the above-described example.

According to an embodiment, a cover plate 260 may be disposed between the first printed circuit board 250 and the rear plate 211. According to an embodiment, the cover plate 260 may be disposed on the first printed circuit board 250. For example, the cover plate 260 may be disposed on a surface facing the -z direction of the first printed circuit board 250.

According to an embodiment, the cover plate 260 may at least partially overlap the first printed circuit board 250 with respect to the z-axis. According to an embodiment, the cover plate 260 may cover at least a partial area of the first printed circuit board 250. Through this, the cover plate 260 may protect the first printed circuit board 250 from physical impact or prevent the connector coupled to the first printed circuit board 250 from being separated.

According to an embodiment, the cover plate 260 may be fixedly disposed on the first printed circuit board 250 through a coupling member (e.g., a screw), or may be coupled to the frame structure 240 together with the first printed circuit board 250 through the coupling member.

According to an embodiment, the display 201 may be disposed between the frame structure 240 and the front plate 202. For example, a front plate 202 may be disposed on one side (e.g., a +z direction) of the display 201 and a frame structure 240 may be disposed on the other side (e.g., a -z direction).

According to an embodiment, the front plate 202 may be coupled to the display 201. For example, the front plate 202 and the display 201 may adhere to each other through an optical adhesive member (e.g., optically clear adhesive (OCA) or optically clear resin (OCR)) interposed therebetween.

According to an embodiment, the front plate 202 may be coupled to the frame structure 240. For example, the front plate 202 may include an outside portion extending outside the display 201 when viewed in the z-axis direction, and may adhere to the frame structure 240 through an adhesive member (e.g., a double-sided tape) disposed between the outside portion of the front plate 202 and the frame structure 240 (e.g., the sidewall 241). However, it is not limited by the above-described example.

According to an embodiment, the first printed circuit board 250 and/or the second printed circuit board 252 may be equipped with a processor (e.g., a processor 120 of FIG. 1), a memory (e.g., a memory 130 of FIG. 1), and/or an interface (e.g., an interface 177 of FIG. 1). The processor may include, for example, one or more of a central processing unit, an application processor, a graphic processing unit, an image signal processor, a sensor hub processor, or a communication processor. The memory may include, for example, a volatile memory or a non-volatile memory. The interface may include, for example, a high definition multimedia interface (HDMI), a universal serial bus (USB) interface, an SD card interface, and/or an audio interface. The interface may electrically or physically connect the electronic device 101 to an external electronic device, and may include a USB connector, an SD card/MMC connector, or an audio connector. According to an embodiment, the first printed circuit board 250 and the second printed circuit board 252 may be operatively or electrically connected to each other through a connection member (e.g., a flexible printed circuit board).

According to an embodiment, the battery 270 may supply power to at least one component of the electronic device 101. For example, the battery 270 may include a rechargeable secondary cell or a fuel cell. At least a portion of the battery 270 may be disposed on substantially the same plane as the first printed circuit board 250 and/or the second printed circuit board 252.

The electronic device 101 according to an embodiment may include an antenna module (not illustrated) (e.g., an antenna module 197 of FIG. 1). According to an embodiment, the antenna module may be disposed between the rear plate 211 and the battery 270. The antenna module may include, for example, a near field communication (NFC) antenna, a wireless charging antenna, and/or a magnetic secure transmission (MST) antenna. The antenna module, for example, may perform short-range communication with an external device, or wirelessly transmit and receive power to and from the external device.

According to an embodiment, the front camera 205 may be disposed in at least a portion (e.g., a support portion 243) of the frame structure 240 so that the lens may receive external light through a partial area (e.g., a camera area 237) of the front plate 202.

According to an embodiment, the rear camera 212 may be disposed between the frame structure 240 and the rear plate 211. According to an embodiment, the rear camera 212 may be electrically connected to the first printed circuit board 250 through a connection member (e.g., a connector). According to an embodiment, the rear camera 212 may be disposed such that the lens may receive external light through a camera area 284 of the rear plate 211 of the electronic device 101.

According to an embodiment, the camera area 284 may be formed on the surface (e.g., a rear surface 200B of FIG. 2) of the rear plate 211. According to an embodiment, the camera area 284 may be formed to be at least partially transparent so that external light may be incident to the lens of the rear camera 212. According to an embodiment, at least a portion of the camera area 284 may protrude from the surface of the rear plate 211 to a predetermined height. However, it is not limited to thereto, and in another embodiment, the camera area 284 may form a plane substantially the same as the surface of the rear plate 211.

According to an embodiment, the housing(e.g., a housing 210 of FIG. 2) of the electronic device 101 may mean a configuration or structure forming at least a portion of the exterior of the electronic device 101. In this regard, at least a portion of the front plate 202, the frame structure 240, and/or the rear plate 211 forming the exterior of the electronic device 101 may be referred to as the housing of the electronic device 101.

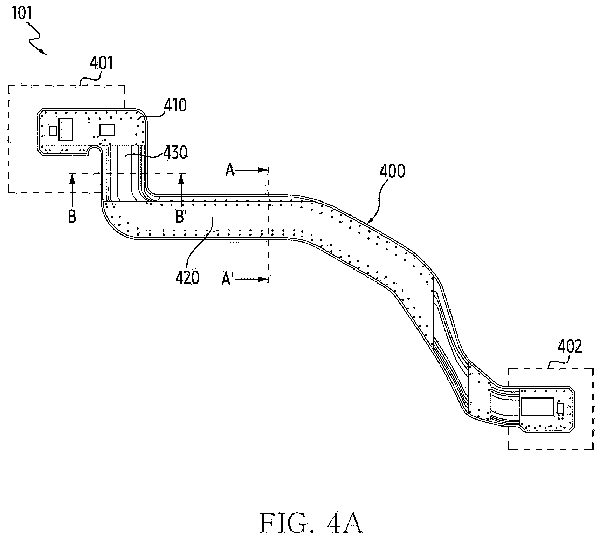

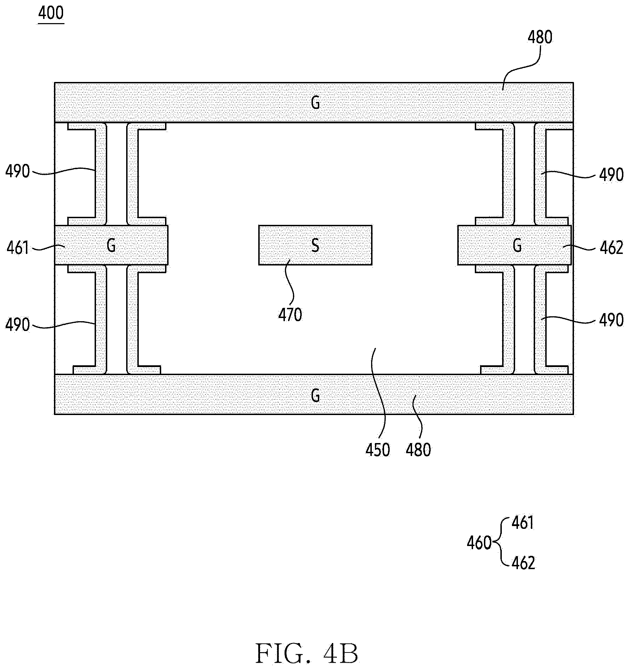

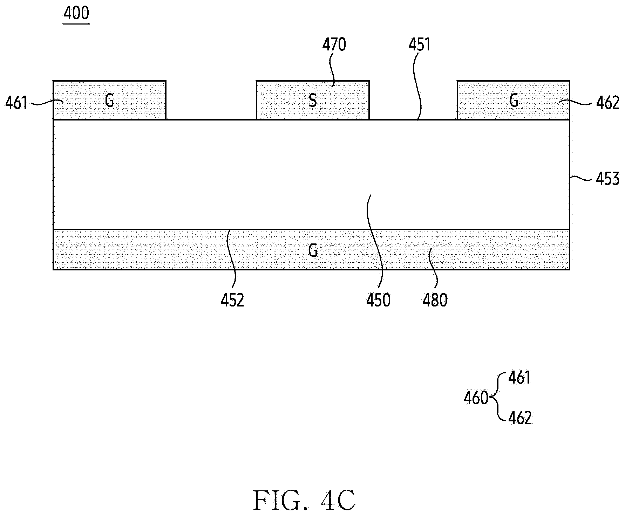

FIG. 4A is a top plan view of a flexible printed circuit board within an exemplary electronic device. FIG. 4B is a cross-sectional view of an exemplary flexible printed circuit board cut along line A-A' of FIG. 4A. FIG. 4C is a cross-sectional view of an exemplary flexible printed circuit board cut along line B-B' of FIG. 4A.

Referring to FIG. 4A, an electronic device 101 may include a first electronic component 401, a second electronic component 402, and a flexible printed circuit board 400.

According to an embodiment, the flexible printed circuit board 400 may provide an electrical path between the first electronic component 401 and the second electronic component 402. For example, the first electronic component 401 and the second electronic component 402 may be spaced apart from each other in a housing (e.g., the housing 210 of FIG. 2) of the electronic device 101. In the housing 210, an end of the flexible printed circuit board 400 may be electrically connected to the first electronic component 401, and another end opposite to the end of the flexible printed circuit board 400 may be electrically connected to the second electronic component 402. The flexible printed circuit board 400 may operably couple the first electronic component 401 and the second electronic component 402, by providing a path through which an electrical signal between the first electronic component 401 and the second electronic component 402 are transmitted.

According to an embodiment, the first electronic component 401 may be referred to the first printed circuit board 250 of FIG. 3. The second electronic component 402 may be referred to the second printed circuit board 252 of FIG. 3. The flexible printed circuit board 400 may electrically connect a plurality of printed circuit boards in the electronic device 101 to each other.

According to an embodiment, the flexible printed circuit board 400 may include a first region 410, a second region 420 spaced apart from the first region 410, and a third region 430 extending from the first region 410 to the second region 420 and deformable.

For example, the first region 410 may be a region connected to the first electronic component 401. For example, the first region 410 may include one end of a flexible printed circuit board 400 connected to the first electronic component 401. For example, the second region 420 may be a region spaced apart from the first region 410 and supported by a support structure (e.g., the support portion 243 of FIG. 3) in the housing 210 of the electronic device 101. However, it is not limited thereto. Although not illustrated, the first region 410 and/or the second region 420 may be a region connected to at least one electronic component among a plurality of electronic components in the electronic device 101.

For example, the third region 430 may be disposed between the first region 410 and the second region 420. For example, the rigidity of the third region 430 may be less than the rigidity of the first region 410 and the rigidity of the second region 420. For example, the third region 430 may be bent to reduce damage to a portion adjacent to the first electronic component 401 of the flexible printed circuit board 400, by including the first region 410 connected to the first electronic component 401. However, it is not limited thereto. The third region 430 may be a deformable region in contact with a region connected to at least one electronic component (e.g., the first electronic component 401, the second electronic component 402) of the electronic device 101 among the flexible printed circuit board 400. The flexible printed circuit board 400 may reduce damage to the flexible printed circuit board 400 by at least one electronic component, by including the deformable third region 430.

Referring to FIGS. 4B and 4C, the flexible printed circuit board 400 may include a substrate 450. The substrate 450 may include a surface on which a conductive pattern is formed. According to an embodiment, the substrate 450 may include polyimide.

According to an embodiment, the flexible printed circuit board 400 may include a signal line 470. The signal line 470 may be a moving path of a signal transmitted from the first electronic component 401 to the second electronic component 402 or a signal transmitted from the second electronic component 402 to the first electronic component 401. The signal line 470 may extend from an end of the flexible printed circuit board 400 connected to the first electronic component 401 to another end of the flexible printed circuit board 400 connected to the second electronic component 402. The signal line 470 may be made of a metal material, but is not limited thereto.

According to an embodiment, the flexible printed circuit board 400 may include a ground region 460 including a first ground plane 461 and a second ground plane 462 spaced apart from the first ground plane 461. The ground region 460 may shield unnecessary electromagnetic waves transmitted to the signal line 470, in order to facilitate signal transmission in the signal line 470. The first ground plane 461 and the second ground plane 462 may be spaced apart from the signal line 470 and may extend along a periphery of the signal line 470. The first ground plane 461 and the second ground plane 462 may be made of a metal material, but are not limited thereto.

According to an embodiment, the flexible printed circuit board 400 may include a ground layer 480 surrounding at least a portion of the substrate 450. The ground layer 480 may be spaced apart from the ground region 460. The ground layer 480 may block coupling of the signal line 470 of the flexible printed circuit board 400 with another signal line outside the flexible printed circuit board 400. The ground layer 480 may extend in a direction parallel to the direction in which the signal line 470, the first ground plane 461, and the second ground plane 462 extend. The ground layer 480 may be made of a metal material, but is not limited thereto.

Although the flexible printed circuit board 400 has been described as including the ground layer 480, it is not limited thereto. The flexible printed circuit board 400 may include a plurality of ground layers. For example, referring to FIG. 4B, ground layers may be disposed on a surface of the substrate 450 and another surface opposite to the surface, respectively.

Referring to FIG. 4B, the substrate 450 in the first region 410 and the second region 420 may surround the ground region 460 and the signal line 470.

According to an embodiment, each of the first region 410 and the second region 420 may include at least one conductive via 490 penetrating at least a portion of the substrate 450. The at least one conductive via 490 may extend from the ground region 460 to the ground layer 480. By electrically connecting the ground region 460 and the ground layer 480, the at least one conductive via 490 may shield unnecessary electromagnetic waves transmitted to the signal line 470 or prevent leakage of electromagnetic waves from the signal line 470. The at least one conductive via 490 may include a plurality of conductive vias formed along the signal line 470 within the first region 410 and the second region 420. The plurality of conductive vias may form a via fence that prevents leakage of electromagnetic waves from the signal line 470.

Referring to FIG. 4C, the substrate 450 may include a first surface 451 in the third region 430, a second surface 452 opposite to the first surface 451, and a third surface 453 between the first surface 451 and the second surface 452. In order to provide flexibility of the third region 430, the thickness of the substrate 450 in the third region 430 may be thinner than the thickness of the substrate 450 in the first region 410 and/or the second region 420.

According to an embodiment, the substrate 450 may be configured such that a material in the first region 410 and the second region 420 and a deformable material connecting the first region 410 and the second region 420 in the third region 430 are different. The substrate 450 disposed in the first region 410 and the second region 420 may have a component ratio different from the substrate 450 disposed in the third region 430. For example, the substrate 450 included in the first region 410 and the second region 420 may have a higher ratio of glass and/or thermoset than the substrate 450 included in the third region 430. For example, in order to provide flexibility to the third region 430, the substrate 450 included in the third region 430 may have a higher ratio of polyimide than the substrate 450 included in the first region 410 and the second region 430.

According to an embodiment, the ground region 460 including the first ground plane 461 and the second ground plane 462 spaced apart from the first ground plane 461 and a signal line 470 disposed between the first ground plane 461 and the second ground plane 462 and providing an electrical path from the first electronic component 401 to the second electronic component 402 may be disposed on the first surface 451 of the substrate 450. For example, the ground region 460, which includes the first ground plane 461 and the second ground plane 462, and the signal line 470 may be exposed to the outside of the flexible printed circuit board 400 through the first surface 451 within the third region 430. For example, the first ground plane 461 and the second ground plane 462 may extend along the signal line 470 on the first surface 451. A structure of the substrate 450 in which the first ground plane 461, the second ground plane 462, and the signal line 470 are disposed may be referred to as a coplanar waveguide structure.

The ground region 460 has been described as including the first ground plane 461 and the second ground plane 462, but is not limited thereto. On the first surface 451, the ground region 460 may include a plurality of ground planes configured to shield unnecessary electromagnetic waves transmitted to the signal line 470, in order to facilitate signal transmission in the signal line 470.

According to an embodiment, the ground layer 480 may be disposed on the second surface 452 of the substrate 450. For example, the ground layer 480 may be disposed on the second surface 452 opposite to the first surface 451 within the third region 430. The ground layer 480 may block an external signal flowing into the second surface 452 or may block coupling of another signal line under the second surface 452 with the signal line 470 of the flexible printed circuit board 400.

According to the above-described embodiment, by including the deformable third region 430, the flexible printed circuit board 400 of the electronic device 101 may increase the degree of freedom of arrangement of a plurality of electronic components in the electronic device 101 and electrically connect the plurality of electronic components to each other. By including the ground region 460 adjacent to the signal line 470 and a ground layer 480 surrounding at least a portion of the substrate 450, the flexible printed circuit board 400 may shield unnecessary electromagnetic waves transmitted to the signal line 470 or prevent leakage of electromagnetic waves from the signal line 470.

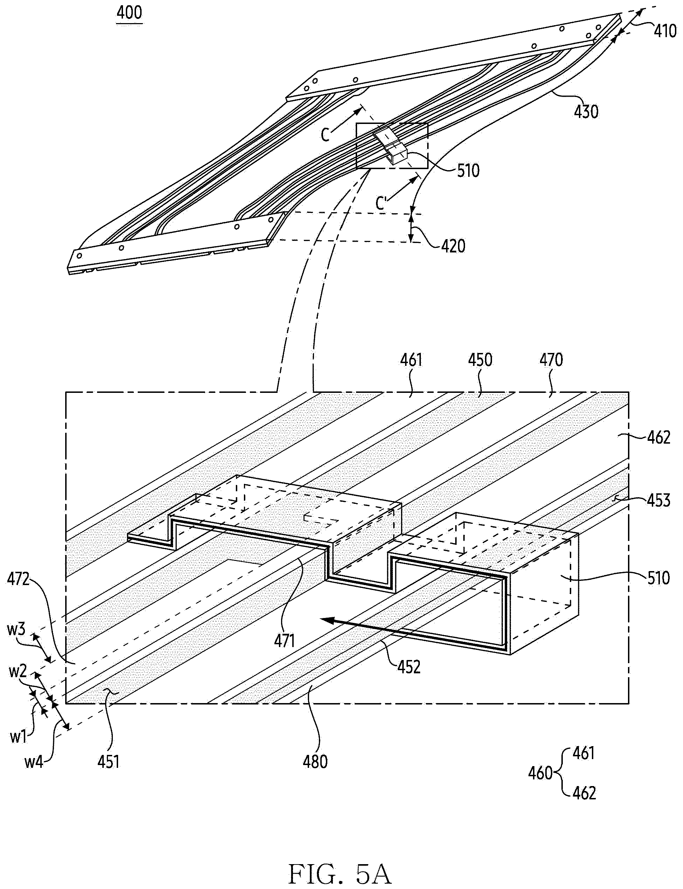

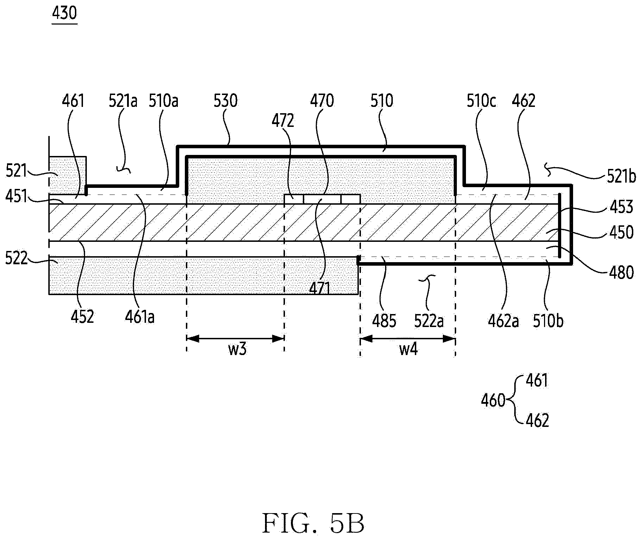

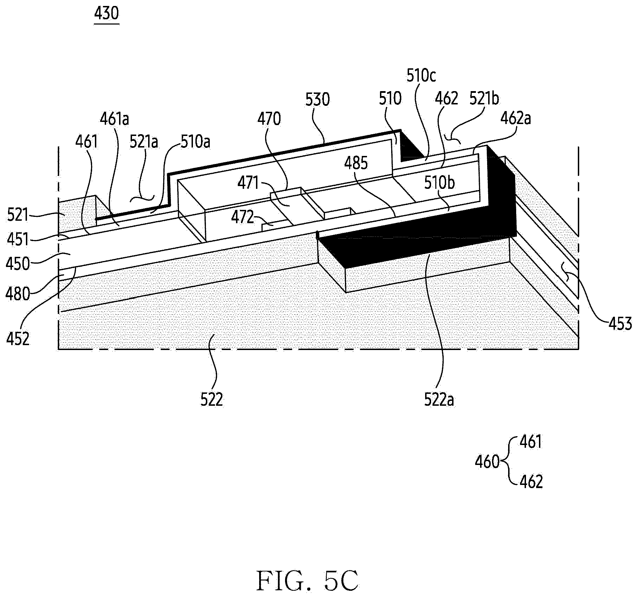

FIG. 5A illustrates an exemplary flexible printed circuit board. FIGS. 5B and 5C illustrate an exemplary flexible printed circuit board cut along line C-C' of FIG. 5A.

Referring to FIGS. 5A, 5B, and 5C, the flexible printed circuit board 400 may include the first region 410, the second region 420, the third region 430, and the substrate 450. The substrate 450 in the third region 430 may include the ground region 460 including the first ground plane 461 and the second ground plane 462, the first surface 451, the second surface 452 opposite the first surface 451 and on which the ground layer 480 is disposed, and the third surface 453 between the first surface 451 and the second surface 452.

Hereinafter, repeated descriptions of the configurations described in FIGS. 4A to 4C will be omitted.

According to an embodiment, the third region 430 may include a conductive member 510 that electrically connects at least a portion of the ground region 460 with the ground layer 480 by extending from the at least a portion of the ground region 460 on the first surface 451 across over the third surface 453 to the ground layer 480 on the second surface 452.

In order to provide flexibility to the third region 430, the conductive member 510 may be made of a film or sponge material, which have conductive and are deformable, but is not limited thereto. The conductive member 510 may be configured so that a portion other than a portion (e.g., a first conductive portion 510a and/or a third conductive portion 510c) in contact with at least a portion of the ground region 460 on the first surface 451 and a portion (e.g., a second conductive portion 510b) in contact with the ground layer 480 on the third surface 453 are insulated from the outside. The conductive member 510 may be connected to each of at least a portion of the ground region 460 and the ground layer 480 by heat compression or hot bar welding, but is not limited thereto. The conductive member 510 may have a clip shape in order to extend from at least a portion of the ground region 460 of the first surface 451 across over the third surface 453 to the ground layer 480 on the second surface 452, but is not limited thereto.

For example, the conductive member 510 may be in contact with the first ground plane 461 and/or the second ground plane 462. The conductive member 510 may extend from the first ground plane 461 and/or the second ground plane 462 across the third surface 453 of the substrate 450 to the ground layer 480.

For example, in order to provide flexibility to the flexible printed circuit board 400, the third region 430 may not include at least one conductive via (e.g., the at least one conductive via 490 of FIG. 4B) penetrating at least a portion of the substrate 450 and electrically connecting the ground region 460 and the ground layer 480. Since the third region 430 cannot form a via fence by not including the at least one conductive via 490, resonance may occur when a signal of a specific frequency band passes through the signal line 470 according to increase of a length of the third region 430 increases. The conductive member 510 may provide substantially the same effect as the at least one conductive via 490 that electrically connects the ground region 460 and the ground layer 480 within the third region 430, by extending in the third region 430 from the ground region 460 across the third surface 453 of the substrate 450 to the ground layer 480.

For example, the conductive member 510 may provide substantially the same effect as at least one conductive via 490 that electrically connects the first ground plane 461 and the ground layer 480 within the third region 430, by contacting with the first ground plane 461 and the ground layer 480. For example, the conductive member 510 may provide substantially the same effect as at least one conductive via 490 that electrically connects the second ground plane 462 and the ground layer 480 within the third region 430, by contacting with the second ground plane 462 and the ground layer 480.

According to an embodiment, when the substrate 450 in the third region 430 is viewed from above, the size of the conductive member 510 may be in a range of 0.09 mm² or more and 0.25 mm² or less. The conductive member 510 has a size within the range of 0.09 mm² or more and 0.25 mm² or less, thereby providing flexibility to the third region 430 and reducing damage to the third region 430 from external impact.

According to an embodiment, the conductive member 510 may be deformable. Since the conductive member 510 is deformable, the conductive member 510 may provide flexibility to the third region 430 of the flexible printed circuit board 400.

According to an embodiment, the third region 430 may further include a first cover layer 521 including a first opening 521a and covering the ground region 460 and the signal line 470, and a second cover layer 522 including a second opening 522a and covering a ground layer 480. The first ground plane 461 may include a first portion 461a in contact with the conductive member 510 through the first opening 521a. The ground layer 480 may include a second portion 485 in contact with the conductive member 510 through the second opening 522a.

The first cover layer 521 and the second cover layer 522 may include solder resist, but are not limited thereto. At least a portion of the first cover layer 521 may be removed for electrical connection between at least a portion of the ground region 460 and the conductive member 510. At least a portion of the second cover layer 522 may be removed for electrical connection between the ground layer 480 and the conductive member 510. The first opening 521a and the third opening 521b of the first cover layer 521 may be a portion of the first cover layer 521 that has been removed for electrical connection between the ground region 460 and the conductive member 510. The second opening 522a of the second cover layer 522 may be a portion of the second cover layer 522 that has been removed for electrical connection between the ground layer 480 and the conductive member 510. The conductive member 510 may be in contact with at least a portion of the ground region 460 and at least a portion of the ground layer 480, through removed portions of the first layer 521 and the second layer 522. The conductive member 510 may be configured to be insulated from the outside except for portions (e.g., the first conductive portion 510a, the second conductive portion 510b, and the third conductive portion 510c) contacting at least a portion of the ground region 460 and at least a portion of the ground layer 480.

For example, the first cover layer 521 may be disposed on the first surface 451 of the substrate 450. The second cover layer 522 may be disposed on the second surface 452 opposite to the first surface 451 of the substrate 450. The first cover layer 521 may include the first opening 521a configured to expose the first portion 461a of the first ground plane 461 to the outside of the first cover layer 521. The second cover layer 522 may include the second opening 522a configured to expose the second portion 485 of the ground layer 480 to the outside of the second cover layer 522. A portion of the conductive member 510 may be in contact with the first portion 461a of the first ground plane 461 through the first opening 521a. A remaining portion of the conductive member 510 may be in contact with the second portion 485 of the ground layer 480 through the second opening 522a. Since the first cover layer 521 covers the signal line 470, the conductive member 510 may extend from the first portion 461a across over the signal line 470 to the second portion 485. The first cover layer 521 may prevent the electrical path provided through the signal line 470 from being shorted by blocking the conductive member 510 from contacting the signal line 470.

According to an embodiment, the third region 430 may further include an insulating member 530 surrounding the conductive member 510. The conductive member 510 may include a first conductive portion 510a exposed from the insulating member 530 and in contact with the first portion 461a and a second conductive portion 510b exposed from the insulating member 530 and in contact with the second portion 485.

For example, the insulating member 530 may cover a surface of the conductive member 510. In a portion corresponding to the first conductive portion 510a of the conductive member 510, the insulating member 530 may be removed so that the first conductive portion 510a contacts the first portion 461a of the first ground plane 461. In a portion corresponding to the second conductive portion 510b of the conductive member 510, the insulating member 530 may be removed so that the second conductive portion 510b contacts the second portion 485 of the ground layer 480. The insulating member 530 may prevent an external signal from flowing into the conductive member 510 and prevent leakage of electromagnetic waves from the signal line 470, by surrounding the conductive member 510 and exposing a portion of the conductive member 510 in contact with at least a portion of the ground region 460 and at least a portion of the ground layer 480.

According to an embodiment, the second ground plane 462 may include a third portion 462a exposed to the outside of the first cover layer 521. The conductive member 510 may further include the third conductive portion 510c exposed from the insulating member 530 and in contact with the third portion 462a. For example, the first cover layer 521 may include a third opening 521b configured to expose the third portion 462a of the second ground plane 462 to the outside of the first cover layer 521. A portion of the insulating member 530 corresponding to the third conductive portion 510c of the conductive member 510 may be removed so that the third conductive portion 510c contacts the third portion 462a of the second ground plane 462. Since the first cover layer 521 covers the signal line 470, a portion of the conductive member 510 may extend from the first conductive portion 510a in contact with the first ground plane 461 on the first surface 451 across over the signal line 470 to the third conductive portion 510c in contact with the second ground plane 462. A remaining portion of the conductive member 510 may extend from the third conductive portion 510c in contact with the second ground plane 462 across over the third surface 453 of the substrate 450 to the second conductive portion 510b in contact with the ground layer 480 on the second surface 452 opposite to the first surface 451. By contacting with the first ground plane 461, the second ground plane 462, and the ground layer 480, the conductive member 510 may provide substantially the same effect as a via fence disposed along the signal line 470 within a region on which the conductive member 510 is disposed, and may reduce the resonance generated from the signal line 470 within a region on which the conductive member 510 is disposed.

According to an embodiment, the insulating member 530 may include at least one of an insulating tape or an electromagnetic interference (EMI) tape. However, it is not limited thereto. Since the conductive member 510 includes the insulating member 530 configured to surround the conductive material in the conductive member 510 and expose at least a portion of the conductive material to the outside, the conductive member 510 may be configured to be electrically connected to the ground region 460 and the ground layer 480 through the openings 521a, 521b, and 522a of the flexible printed circuit board 400.

According to an embodiment, the second ground plane 462 may be arranged in a closer distance to the third surface 453 of the substrate 450 than the first ground plane 461 in the third region 430. The conductive member 510 may extend from the first ground plane 461 to the ground layer 480 across over the signal line 470 and the third surface 453. According to an embodiment, the signal line 470 may include a fourth portion 471 overlapping the conductive member 510 when the first surface 451 is viewed from above and a fifth portion 472 extending from the fourth portion 471. A width w1 of the fourth portion 471 may be smaller than a width w2 of the fifth portion 472.

For example, a portion of the conductive member 510 on the first surface 451 may extend from the first ground plane 461 to the second ground plane 462 across over the signal line 570 upward. Since the portion of the conductive member 510 extends upward across over the fourth portion 471 of the signal line 470, the width w1 of the fourth portion 471 may be smaller than the width w2 of the fifth portion 472 extending from the fourth portion 471 for impedance matching. For example, since the conductive member 510 with conductivity is disposed on the signal line 470, the impedance of the fourth portion 471 overlapping the conductive member 510 may be lowered. The fourth portion 471 may be configured to reduce a line width of the signal line 470 for 50 ohm matching.

According to an embodiment, a distance w3 from the signal line 470 to the first ground plane 461 may be the same as a distance w4 from the signal line 470 to the second ground plane 462. Since the distance w3 is substantially the same as the distance w4, the ground region 460 including the first ground plane 461 and the second ground plane 462 may stabilize a signal transmitted through the signal line 470.

According to the above-described embodiment, the flexible printed circuit board 400 may provide flexibility to the third region 430 and reduce resonance generated from the signal line 470, by including the conductive member 510 in contact with the ground region 460 and the ground layer 480 within the deformable third region 430.

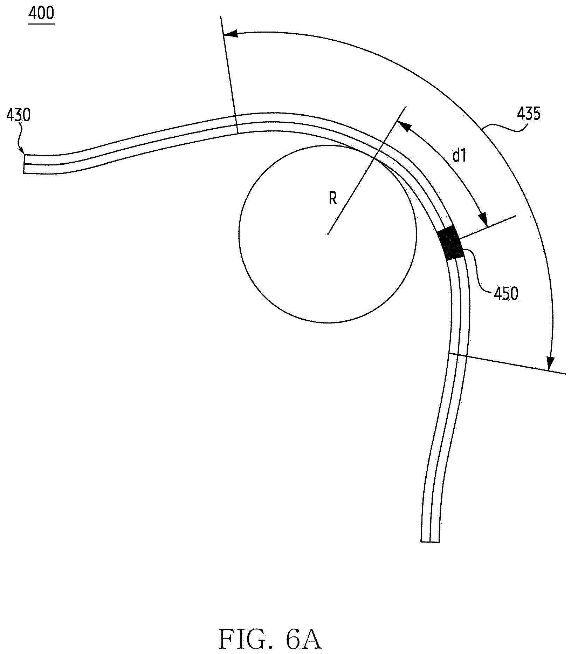

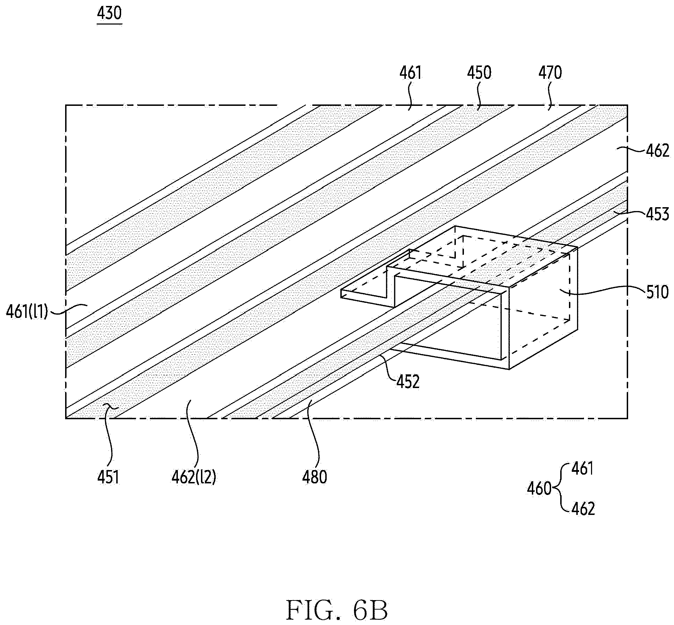

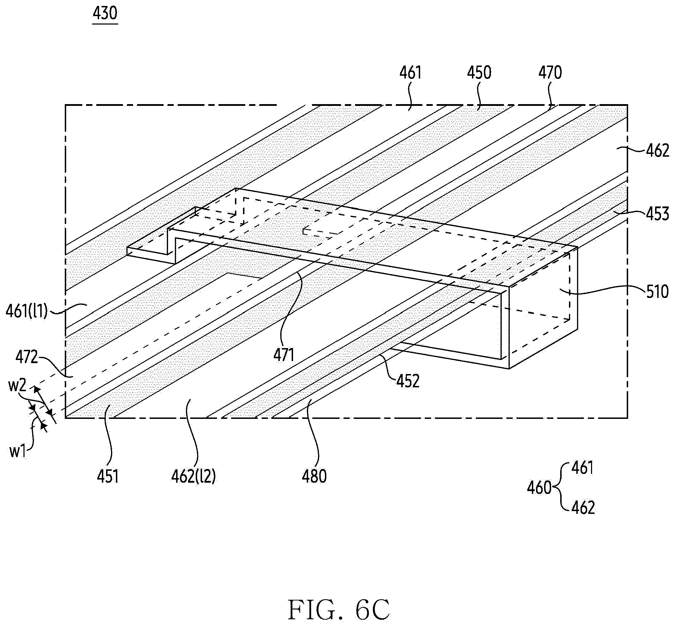

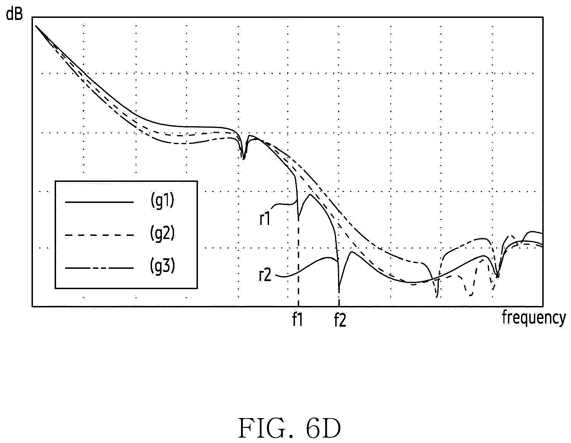

FIGS. 6A, 6B, and 6C illustrate a third region of an exemplary flexible printed circuit board. FIG. 6D is a graph illustrating a relationship between a signal loss of a signal line in a flexible printed circuit board and a frequency.

Referring to FIGS. 6A, 6B, and 6C, the flexible printed circuit board 400 may include the deformable third region 430 and the substrate 450. The substrate 450 in the third region 430 may include the first surface 451 on which the ground region 460 including the first ground plane 461 and the second ground plane 462 and the signal line 470 are disposed, the second surface 452 opposite to the first surface 451 and on which the ground layer 480 is disposed, and the third surface 453 between the first surface and the second surface. By extending from at least a portion of the ground region 460 on the first surface 451 across over the third surface 453 to the ground layer 480 on the second surface 452, the third region 430 may include the conductive member 510 that electrically connects the at least a portion of the ground region 460 with the ground layer 480.

According to an embodiment, the third region 430 may include a bending region 435 having a curvature. A length l1 of the first ground plane 461 in the third region 430 may be shorter than a length l2 of the second ground plane 462 in the third region 430. For example, since the third region 430 includes the bending region 435 bent to have a curvature, the length 11 of the first ground plane 461 in the third region 430 may be shorter than the length l2 of the second ground plane 462.

Referring to FIG. 6A, the conductive member 510 may be located within a first distance d1 from a portion having a minimum curvature radius R among the bending region 435. According to an embodiment, the first distance d1 may be located within a range of 0.75 mm or more and 1.25 mm or less. For example, the portion having a minimum curvature radius R among the bending region 435 may be a portion having a greatest bending stress among the bending region 435. The conductive member 510 may reduce damage to the bending region 435 by an external impact, by being spaced apart from the portion having a minimum curve radius R among the bending region 435 in a distance d1 of 0.75mm or more and 1.25mm or less.

According to an embodiment, as the lengths of the first ground plane 461 and the second ground plane 462 are changed by the bending region 435, multiple resonances may occur from the signal line 470 between the first ground plane 461 and the second ground plane 462. As an end of the conductive member 510 is in contact with the ground layer 480 on the second surface 452 and another end of the conductive member 510 is in contact with either the first ground plane 461 or the second ground plane 462, a portion of the multiple resonances generated from the signal line 470 may be selectively removed for impedance matching.

For example, referring to FIG. 6B, the conductive member 510 may extend from the second ground plane 462 among the first ground plane 461 and the second ground plane 462 across over the third surface 453 of the substrate 450 to the ground layer 480. By extending from the second ground plane 462 to the ground layer 480, the conductive member 510 may remove a first resonance (e.g., a first resonance r1 of FIG. 6D) generated when a signal in a first frequency (e.g., a first frequency f1 of FIG. 6D) band passes through the signal line 470.

For example, referring to FIG. 6C, the conductive member 510 may extend from the first ground plane 461 among the first ground plane 461 and the second ground plane 462 across over the signal line 470, the second ground plane 462, and the third surface 453 of the substrate 450 to the ground layer 480. Since a portion of the conductive member 510 overlaps the fourth portion 471 of the signal line 470, the width w1 of the fourth portion 471 may be smaller than the width w2 of the fifth portion 472 extending from the fourth portion 471 for impedance matching. Since the conductive member 510 crosses over the second ground plane 462, the conductive member 510 may remove a second resonance (e.g., a second resonance r2 of FIG. 6D) generated when a signal in a band of a second frequency (e.g., a second frequency f2 of FIG. 6D) different from the first frequency f1 passes through the signal line 470.

Referring to FIG. 6D, a graph g1 shows a relationship between a frequency and signal loss of the signal line 470 in the third region 430, a graph g2 shows a relationship between a frequency and signal loss of the signal line 470 in the third region 430 according to a comparative example, and a graph g3 shows a relationship between a frequency and signal loss of the signal line 470 in the third region 430 according to an embodiment.

Referring to the graph g1, in case that the third region 430 does not include at least one conductive via (e.g., the at least one conductive via 490 of FIG. 4B) and the conductive member 510 so that the ground region 460 and the ground layer 480 are not electrically connected, when a signal having the first frequency f1 passes through the signal line 470, the first resonance r1 may be generated. When a signal having the second frequency f2 different from the first frequency f1 passes through the signal line 470, the second resonance r2 different from the first resonance r1 may be generated.

Referring to the graph g2, in case that the third region 430 includes at least one conductive via 490 penetrating the substrate 450 from the ground region 460 and connected to the ground layer 480, the first resonance r1 and the second resonance r2 may be removed by the at least one conductive via 490.

Referring to the graph g3, in case that the third region 430 includes the conductive member 510 extending from at least a portion of the ground region 460 on the first surface 451 of the substrate 450 across over the third surface to the ground layer 480 on the second surface 452 opposite to the first surface, the first resonance r1 and/or the second resonance r2 may be removed for impedance matching.

For example, as illustrated in FIG. 5A, the conductive member 510 may remove the first resonance r1 and the second resonance r2 by contacting with the first ground plane 461, the second ground plane 462, and the ground layer 480.

For example, as illustrated in FIG. 6B, the conductive member 510 may selectively remove the first resonance r1 among the first resonance r1 and the second resonance r2, by contacting with the second ground plane 462 among the first ground plane 461 and the second ground plane 462 and the ground layer 480 for impedance matching.

For example, as illustrated in FIG. 6C, the conductive member 510 may selectively remove the second resonance r2 among the first resonance r1 and the second resonance r2, by contacting with the first ground plane 461 among the first ground plane 461 and the second ground plane 462 and the ground layer 480.

According to the above-described embodiment, the third region 430 of the flexible printed circuit board 400 may provide additional space for electronic components of an electronic device (e.g., the electronic device 101 of FIG. 1) and provide flexibility to the third region 430, by including the bending region 435. The third region 430 may selectively remove a portion of the multiple resonances generated from the signal line 470 between the first ground plane 461 and the second ground plane 462, by including a conductive member 510 in which one end is in contact with the ground layer 480 on the second surface 452, and another end is in contact with either the first ground plane 461 or the second ground plane 462.

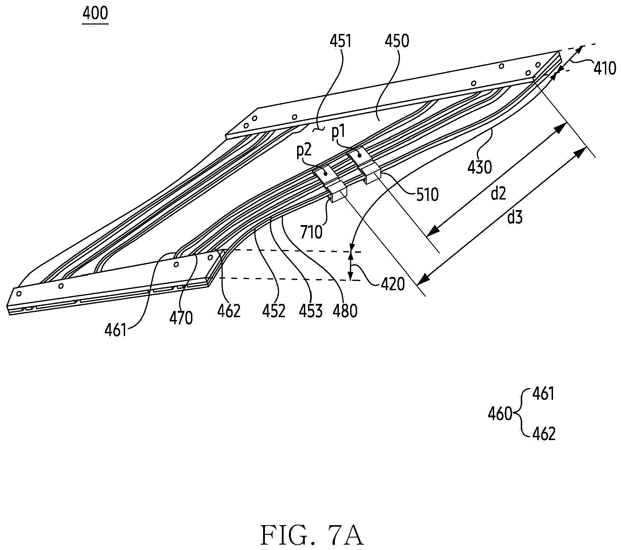

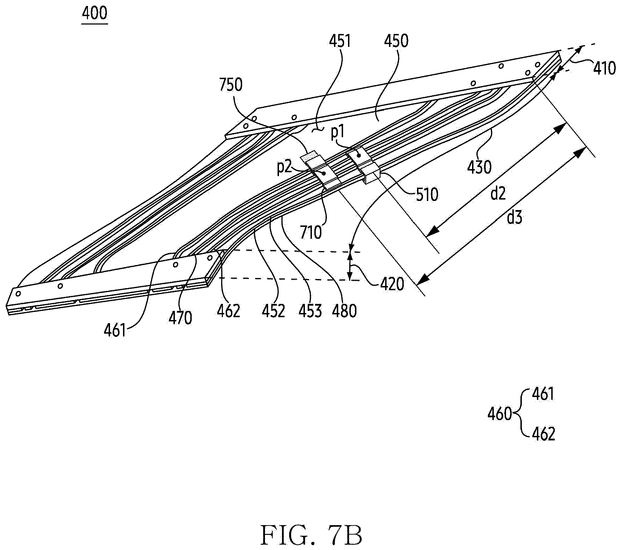

FIGS. 7A and 7B illustrate an exemplary flexible printed circuit board.

Referring to FIGS. 7A and 7B, the flexible printed circuit board 400 may include the first region 410, the second region 420, the third region 430, and the substrate 450. The substrate 450 may include the ground region 460 including the first ground plane 461 and the second ground plane 462, and include the first surface 451 in the third region 430 including the signal line 470, the second surface 452 opposite to the first surface 451 and including the ground layer 480, and the third surface 453 between the first surface and the second surface. By extending from at least a portion of the ground region 460 on the first surface 451 across over the third surface 453 to the ground layer 480 on the second surface 452, the third region 430 may include the conductive member 510 that electrically connects the at least a portion of the ground region 460 with the ground layer 480.

According to an embodiment, the third region 430 may further include another conductive member 710 extending from another portion of the ground region 460 across over the third surface 453 of the substrate 450 to the ground layer 480 and spaced apart from the conductive member 510.

For example, as a length of the third region 430 increases, multiple resonances may occur from the signal line 470 in the third region 430. One resonance may occur at a first point p1 within the third region 430, which is spaced apart from the first region 410 by a second distance d2. Another resonance may occur at a second point p2 within the third region 430, which is spaced apart from the first region 410 by a third distance d3 greater than the second distance d2. The conductive member 510 may be disposed at the first point p1, in order to remove the one resonance, and another conductive member 710 may be disposed at the second point p2, in order to remove the other one resonance.

Although the third region 430 has been described as including the conductive member 510 and the other conductive member 710, it is not limited thereto. The third region 430 may include a plurality of conductive members. As a length of the third region 430 increases, multiple resonances may occur at a plurality of points in the third region 430. The plurality of conductive members may be disposed on each of the plurality of points to electrically connect the ground region 460 and the ground layer 480, thereby removing the multiple resonances.

According to an embodiment, the ground plane to which the conductive member 510 and the other conductive member 710 are connected may be the same or different. For example, each of the conductive member 510 and the other conductive member 710 may be connected to the first ground plane 461 and the second ground plane 462. For example, the conductive member 510 may be connected to the first ground plane 461 among the first ground plane 461 and the second ground plane 462, and the other conductive member 710 may be connected to the second ground plane 462 among the first ground plane 461 and the second ground plane 462. However, it is not limited thereto.

Referring to FIG. 7B, the flexible printed circuit board 400 may further include a slit 750 penetrating the flexible printed circuit board 400 in the third region 430. The conductive member 510 may extend from the ground region 460 on the first surface 451 across over the third surface 453 to the ground layer 480 on the second surface 452 opposite to the first surface 451. Unlike the conductive member, the other conductive member 710 may penetrate the flexible printed circuit board 400 by passing the slit 750 from the ground region 460 on the first surface 451, and extend to the ground layer 480 on the second surface 452 opposite to the first surface 451.

According to the above-described embodiment, the third region 430 of the flexible printed circuit board 400 may remove multiple resonances generated from each of a plurality of points in the third region 430, by including a plurality of conductive members each extending from the ground region 460 across over the third surface 451 to the ground layer 480.

According to an embodiment, an electronic device (e.g., the electronic device 101 of FIG. 1) may comprise a first electronic component (e.g., the first electronic component 401 of FIG. 4A), a second electronic component (e.g., the second electronic component 402 of FIG. 4A), and a flexible printed circuit board (e.g., the flexible printed circuit board 400 of FIG. 4A) for an electrical path between the first electronic component and the second electronic component including a first region (e.g., the first region 410 of FIG. 4A), a second region (e.g., the second region 420 of FIG. 4A) spaced apart from the first region, a third region (e.g., the third region 430 of FIG. 4A) that extends from the first region to the second region and is deformable, and a substrate (e.g., the substrate 450 of FIG. 4B). The substrate in the third region may include a first surface (e.g., the first surface 451 of FIG. 4C) on which a ground region (e.g., the ground region 460 of FIG. 4C) including a first ground plane (e.g., the first ground plane 461 of FIG. 4C) and a second ground plane (e.g., the second ground plane 462 of FIG. 4C) spaced apart from the first ground plane, and a signal line (e.g., the signal line 470 of FIG. 4C) between the first ground plane and the second ground plane and providing the electrical path are disposed, a second surface (e.g., the second surface 452 of FIG. 4C) opposite to the first surface and on which a ground layer (e.g., the ground layer 480 of FIG. 4C) is disposed, and a third surface (e.g., the third surface 453 of FIG. 4C) between the first surface and the second surface. The third region may include a conductive member (e.g., the conductive member 510 of FIG. 5A) extending from at least a portion of the ground region on the first surface across over the third surface to the ground layer on the second surface so as to electrically connecting at least a portion of the ground region and the ground layer. According to the above-described embodiment, the electronic device may provide additional space for electronic components by including the flexible printed circuit board. The flexible printed circuit board may reduce damage to the flexible printed circuit board due to external impact, by including the third region. By including the conductive member, the third region may provide flexibility to the third region and remove resonance generated from the signal line. In the above-described embodiment, there may be various effects including the above-described effects.

According to an embodiment, the third region may further include a first cover layer (e.g., the first cover layer 521 of FIG. 5B) covering the ground region and the signal line and including a first opening (e.g., the first opening 521a of FIG. 5B) and a second cover layer (e.g., the second cover layer 522 of FIG. 5B) covering the ground layer and including a second opening (e.g., the second opening 522a of FIG. 5B). The first ground plane may include a first portion (e.g., the first portion 461a of FIG. 5B) contacting the conductive member through the first opening, and the ground layer may include a second portion (e.g., the second portion 485 of FIG. 5B) contacting the conductive member through the second opening. According to the above-described embodiment, the third region may block an external signal flowing into a signal line from the outside of the flexible printed circuit board, by including the first cover layer and the second cover layer. In the above-described embodiment, there may be various effects including the above-described effects.

According to an embodiment, the third region may further include an insulating member (e.g., the insulating member 530 of FIG. 5B) surrounding the conductive member. The conductive member may include a first conductive portion (e.g., the first conductive portion 510a of FIG. 5B) exposed from the insulating member and contacting the first portion and a second conductive portion (e.g., the second conductive portion 510b of FIG. 5B) exposed from the insulating member and contacting the second portion. According to the above-described embodiment, the third region may block an external signal flowing into the conductive member and the signal line from the outside of the flexible printed circuit board, by including the insulating member. In the above-described embodiment, there may be various effects including the above-described effects.

According to an embodiment, the first cover layer may further include a third opening (e.g., the third opening 521b of FIG. 5B) spaced apart from the first opening. The second ground plane may include a third portion (e.g., the third portion 462a of FIG. 5B) contacting the conductive member through the third opening. The conductive member may further include a third conductive portion (e.g., the third conductive portion 510c of FIG. 5B) exposed from the insulating member and contacting the third portion. According to the above-described embodiment, the second ground plane may be electrically connected to the third conductive portion of the conductive member by including the third portion. In the above-described embodiment, there may be various effects including the above-described effects.

According to an embodiment, the second ground plane may be disposed in a closer distance to the third surface of the substrate than the first ground plane in the third region, and the conductive member may extend from the first ground plane to the ground layer by crossing over the signal line and the third surface. According to the above-described embodiment, the conductive member may electrically connect the first ground plane and the ground layer by extending from the first ground plane across over the signal line and the third surface to the ground layer. In the above-described embodiment, there may be various effects including the above-described effects.

According to an embodiment, the signal line may include a fourth portion (e.g., the fourth portion 471 of FIG. 5A) overlapping the conductive member when the first surface is viewed from above and a fifth portion (e.g., the fifth portion 472 of FIG. 5A) extending from the fourth portion. A width (e.g., the width w1 of FIG. 5A) of the fourth portion is smaller than a width (e.g., the width w2 of FIG. 5A) of the fifth portion. According to the above-described embodiment, since the width of the fourth portion is smaller than the width of the fifth portion, the signal line may stabilize a signal passing through the signal line by making the width of the fourth portion smaller than the width of the fifth portion. In the above-described embodiment, there may be various effects including the above-described effects.

According to an embodiment, a distance (e.g., the distance w3 of FIG. 5A) from the signal line to the first ground plane may be the same as a distance (e.g., the distance w4 of FIG. 5A) from the signal line to the second ground plane. According to the above-described embodiment, since the distance from the signal line to the first ground plane is the same as the distance from the signal line to the second ground plane, a flexible printed circuit board may stabilize a signal passing through the signal line. In the above-described embodiment, there may be various effects including the above-described effects.

According to an embodiment, each of the first region and the second region may include at least one conductive via (e.g., the at least one conductive via 490 of FIG. 4B) penetrating at least a portion of the substrate. According to the above-described embodiment, each of the first region and the second region may electrically connect the ground region and the ground layer, by including the at least one conductive via. In the above-described embodiment, there may be various effects including the above-described effects.

According to an embodiment, the third region further includes a bending region (e.g., the bending region 435 of FIG. 6A) having curvature, and a length (e.g., the length l1 of FIG. 6B) of the first ground plane in the third region may be shorter than a length (e.g., the length l2 of FIG. 6B) of the second ground plane in the third region. According to the above-described embodiment, the third region may include the bending region, thereby providing additional space for electronic components inside the electronic device and providing flexibility to the third region. In the above-described embodiment, there may be various effects including the above-described effects.

According to an embodiment, the conductive member may extend from the first ground plane among the first ground plane and the second ground plane across over the signal line, the second ground plane, and the third surface to the ground layer. According to the above-described embodiment, the conductive member may selectively remove at least a portion of multiple resonances generated from the signal line by extending from the first ground plane across over the signal line, the second ground plane, and the third surface to the ground layer. In the above-described embodiment, there may be various effects including the above-described effects.

According to an embodiment, the conductive member may extend from the second ground plane among the first ground plane and the second ground plane across over the third surface to the ground layer. According to the above-described embodiment, the conductive member may selectively remove at least a portion of multiple resonances generated from the signal line, by extending from the second ground plane to the ground layer. In the above-described embodiment, there may be various effects including the above-described effects.

According to an embodiment, the third region may further include another conductive member spaced apart from the conductive member and extending from another portion of the ground region to the ground layer across over the third surface. According to the above-described embodiment, the third region may remove multiple resonances generated from the signal line by including a plurality of conductive members. In the above-described embodiment, there may be various effects including the above-described effects.

According to an embodiment, the third region may further include a bending region having curvature, and the conductive member may be located in a distance of 0.75mm or more and 1.25mm or less from a portion having minimum curvature radius of the bending region. According to the above-described embodiment, the conductive member may be located in a distance of 0.75mm or more and 1.25mm or less from a portion having minimum curvature radius of the bending region, thereby reducing damage to the bending region by an external impact. In the above-described embodiment, there may be various effects including the above-described effects.

According to an embodiment, the conductive member may be deformable. According to the above-described embodiment, the conductive member may be deformable, thereby providing flexibility to the third region and reducing damage of the third region from external impact. In the above-described embodiment, there may be various effects including the above-described effects.

According to an embodiment, the conductive member may include at least one of insulating tape, and electromagnetic interference (EMI) tape. According to the above-described embodiment, the conductive member may block an external signal flowing into the signal line from the outside of the flexible printed circuit board and electrically connect the ground region and the ground layer, by including at least one of the insulating tape and the EMI tape. In the above-described embodiment, there may be various effects including the above-described effects.

According to an embodiment, an electronic device may comprise a first electronic component, a second electronic component, and a flexible printed circuit board for an electrical path between the first electronic component and the second electronic component including a first region, a second region spaced apart from the first region, a third region that extends from the first region to the second region and is deformable, and a substrate . The substrate in the third region may include a first surface on which a ground region including a first ground plane and a second ground plane spaced apart from the first ground plane and disposed along the third surface, and a signal line between the first ground plane and the second ground plane and providing the electrical path are disposed, a second surface opposite to the first surface and on which a ground layer is disposed, and a third surface between the first surface and the second surface. Each of the first region and the second region may include at least one conductive via penetrating at least a portion of the substrate. The third region may include a conductive member extending from at least a portion of the ground region on the first surface across over the third surface to the ground layer on the second surface so as to electrically connecting at least a portion of the ground region and the ground layer. According to the above-described embodiment, the electronic device may provide additional space for electronic components by including the flexible printed circuit board. The flexible printed circuit board may reduce damage to the flexible printed circuit board due to external impact, by including the third region. Each of the first region and the second region may include at least one conductive via, thereby electrically connecting the ground region and the ground layer. By including the conductive member, the third region may provide flexibility to the third region and remove resonance generated from the signal line. In the above-described embodiment, there may be various effects including the above-described effects.

According to an embodiment, the third region may further include a first cover layer covering the ground region and the signal line and including a first opening and a second cover layer covering the ground layer and including a second opening. The first ground plane may include a first portion contacting the conductive member through the first opening, and the ground layer may include a second portion contacting the conductive member through the second opening. According to the above-described embodiment, the third region may block an external signal flowing into a signal line from the outside of the flexible printed circuit board, by including the first cover layer and the second cover layer. In the above-described embodiment, there may be various effects including the above-described effects.

According to an embodiment, the third region may further include an insulating member surrounding the conductive member, and the conductive member may include a first conductive portion exposed from the insulating member and contacting the first portion and a second conductive portion exposed from the insulating member and contacting the second portion. According to the above-described embodiment, the third region may block an external signal flowing into the conductive member and the signal line from the outside of the flexible printed circuit board, by including the insulating member. In the above-described embodiment, there may be various effects including the above-described effects.

According to an embodiment, the third region further includes a bending region having curvature, and a length of the first ground plane in the third region may be shorter than a length of the second ground plane in the third region. The conductive member may extend from the first ground plane among the first ground plane and the second ground plane across over the signal line, the second ground plane, and the third surface to the ground layer. According to the above-described embodiment, the third region may include the bending region, thereby providing additional space for electronic components inside the electronic device and providing flexibility to the third region. In the above-described embodiment, there may be various effects including the above-described effects.

According to an embodiment, the third region may further include another conductive member spaced apart from the conductive member and extending from another portion of the ground region to the ground layer across over the third surface. According to the above-described embodiment, the third region may remove multiple resonances generated from the signal line by including a plurality of conductive members. In the above-described embodiment, there may be various effects including the above-described effects.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a first electronic component (401);
a second electronic component (402); and
a flexible printed circuit board (400) for an electrical path between the first electronic component (401) and the second electronic component (402) including a first region (410), a second region (420) spaced apart from the first region (410), a third region (430) that extends from the first region (410) to the second region (420) and is deformable, and a substrate (450); and,
wherein, the substrate (450) in the third region (430) includes:
a first surface (451) on which a ground region (460) including a first ground plane (461) and a second ground plane (462) spaced apart from the first ground plane (461), and a signal line (470) between the first ground plane (461) and the second ground plane (462) and providing the electrical path, are disposed;
a second surface (452) opposite to the first surface (451) and on which a ground layer (480) is disposed; and
a third surface (453) between the first surface (451) and the second surface (452); and,
wherein, the third region (430) includes a conductive member (510) extending from at least a first portion of the ground region (460) on the first surface (451) across over the third surface (453) to the ground layer (480) on the second surface (452) so as to electrically connecting at least the first portion of the ground region (460) and the ground layer (480).

2. The electronic device (101) of claim 1,
wherein, the third region (430) further includes:
a first cover layer (521) covering the ground region (460) and the signal line (470) and including a first opening (521a); and
a second cover layer (522) covering the ground layer (460) and including a second opening (522a); and,
wherein, the first ground plane (461) includes a first portion (461a) contacting the conductive member (510) through the first opening (521a), and
wherein, the ground layer (480) includes a second portion (485) contacting the conductive member (460) through the second opening (522a).

3. The electronic device (101) of claim 1 or 2,
wherein, the third region (430) further includes an insulating member (530) surrounding the conductive member (510), and
wherein, the conductive member (510) includes:
a first conductive portion (510a) exposed from the insulating member (530) and contacting the first portion (461a); and
a second conductive portion (510b) exposed from the insulating member (530) and contacting the second portion (485).

4. The electronic device (101) of any one of claims 1 to 3,
wherein, the first cover layer (521) further includes a third opening (521b) spaced apart from the first opening (521a), and
wherein, the second ground plane (462) includes a third portion (462a) contacting the conductive member (510) through the third opening (521b), and
the conductive member (510) further includes a third conductive portion (510c) exposed from the insulating member (530) and contacting the third portion (462a).

5. The electronic device of any one of claims 1 to 4,
wherein, the second ground plane (462) is disposed in a closer distance to the third surface (453) of the substrate (450) than the first ground plane (461) in the third region (430), and
wherein, the conductive member (510) extends from the first ground plane (461) to the ground layer (480) by crossing over the signal line (470) and the third surface (453).

6. The electronic device (101) of any one of claims 1 to 5,
wherein, the signal line (470) includes:
a fourth portion (471) overlapping the conductive member (510) when the first surface (451) is viewed from above; and
a fifth portion (472) extending from the fourth portion (471), and
wherein, a width of the fourth portion is smaller than a width of the fifth portion.

7. The electronic device (101) of any one of claims 1 to 6,
wherein, a distance from the signal line (470) to the first ground plane (461) is correspond to a distance from the signal line (470) to the second ground plane (462).

8. The electronic device (101) of any one of claims 1 to 7,
wherein, each of the first region (410) and the second region (420) includes at least one conductive via (490) penetrating at least a portion of the substrate (450).

9. The electronic device (101) of any one of claims 1 to 8,
wherein, the third region (430) further includes a bending region (435) having curvature, and
wherein, a length of the first ground plane (461) in the third region (430) is shorter than a length of the second ground plane (462) in the third region (430).

10. The electronic device (101) of any one of claims 1 to 9,
wherein, the conductive member (510) extends from the first ground plane (461) among the first ground plane (461) and the second ground plane (462), across over the signal line (470), the second ground plane (462), and the third surface (453), to the ground layer (480).

11. The electronic device (101) of any one of claims 1 to 10,
wherein, the conductive member (510) extends from the second ground plane (462) among the first ground plane (461) and the second ground plane (462), across over the third surface (453), to the ground layer (480).

12. The electronic device (101) of any one of claims 1 to 11,
wherein, the third region (430) further includes another conductive member (710) spaced apart from the conductive member (510) and extending from another portion of the ground region (460) to the ground layer (480) across over the third surface (453).

13. The electronic device (101) of any one of claims 1 to 12,
wherein, the third region (430) further includes the bending region (435) having curvature, and
wherein the conductive member (510) is located in a distance of 0.75mm or more and 1.25mm or less from a portion having minimum curvature radius of the bending region (435).

14. The electronic device (101) of any one of claims 1 to 13,
wherein, the conductive member (510) is deformable.

15. The electronic device (101) of any one of claims 1 to 14,
wherein, the conductive member (510) includes at least one of insulating tape, and electromagnetic interference, EMI, tape.
